# EUROPEAN PATENT APPLICATION

(11) **EP 4 848 913 A1**
(43) Date of publication of application: **02.12.2026**
(21) Application number: 24920254.0
(22) Date of filing: 18.09.2024
(51) Int. Cl.: H05K 5/02, H02M 7/48

(54) **ELECTRICAL DEVICE, ELECTRICAL DEVICE HOUSING, AND AIRCRAFT**

(30) Priority: 23.01.2024 JP 2024008283
(71) Applicant: Hitachi, Ltd., Tokyo 100-8280 (JP)
(72) Inventor: YOSHITAKE Yuuichiro, Tokyo 100-8280 (JP); KAMIZUMA Hiroshi, Tokyo 100-8280 (JP); HATANAKA Ayumu, Tokyo 100-8280 (JP); NAMBA Akihiro, Tokyo 100-8280 (JP)
(74) Representative: Mewburn Ellis LLP
(86) International application number: PCT/JP2024/033332
(87) International publication number: WO 2025/158706

(57) **Abstract**

Provided are: an electrical device capable of maintaining a dry state of gas in a housing while withstanding an expansion force of the gas in the housing; an electrical device housing; and an aircraft.

The electrical device comprises: an electrical component; a housing 5 that stores the electrical component; a cover 6 that is connected to the housing 5 and covers an opening of the housing 5; and a sealing part 11 that seals between a connection surface of the housing 5 and a connection surface of the cover 6 facing each other. A dry gas is sealed inside the housing 5 and the cover 6. The sealing part 11 comprises a sealing material 12 having elasticity, and a sealing material 13 which is disposed outside the sealing material 12 and has moisture resistance.

## Description

### Technical Field

The present invention relates to an electrical device, an electrical device housing, and an aircraft.

### Background Art

PTL 1 discloses a power conversion device, which is one electrical device and is mounted on an aircraft (moving body). The power conversion device includes electrical components such as a power semiconductor module, and an electrical device housing storing the electrical components. The electrical device housing seals a dry gas therein. Accordingly, condensation in the electrical device housing due to environmental changes is prevented, and failure or deterioration of the electrical components is prevented.

### Citation List

### Patent Literature

PTL 1: Japanese Patent No. 6878712

### Summary of Invention

### Technical Problem

Although not described in PTL 1, in general, an electrical device housing has a divided structure. The electrical device housing includes a housing storing electrical components, and a cover that is connected to the housing and covers an opening of the housing. Therefore, a sealing material that seals between a connection surface of the housing and a connection surface of the cover facing each other needs to be provided.

Here, when a dry gas is sealed in the electrical device housing as described in PTL 1, a sealing material having moisture resistance needs to be provided. However, a sealing material having moisture resistance alone may not be able to maintain the dry state of the gas in the electrical device housing. More specifically, for example, when the moving body moves to a high place, pressure outside the electrical device housing mounted on the moving body decreases. Accordingly, an expansion force of the gas due to a difference between pressure inside the electrical device housing and pressure outside the electrical device housing increases, and the expansion force of the gas acts on the sealing material. Because the sealing material having moisture resistance does not have elasticity, the sealing material having moisture resistance may be unable to withstand the expansion force of the gas and may be damaged. Therefore, the dry state of the gas in the electrical device housing may not be able to be maintained.

The present invention has been made in view of the matter described above, and one object of the present invention is to maintain a dry state of gas in an electrical device housing while withstanding an expansion force of the gas in the electrical device housing.

### Solution to Problem

To solve the problem described above, a configuration described in the claims is applied. The present invention includes a plurality of configurations for solving the problem described above, and one example of the plurality of configurations is as follows: in an electrical device including an electrical component, a housing that stores the electrical component, a cover that is connected to the housing and covers an opening of the housing, and a sealing part that seals between a connection surface of the housing and a connection surface of the cover facing each other, the electrical device having a dry gas sealed inside the housing and the cover, in which the sealing part includes a first sealing material having elasticity and a second sealing material disposed outside the first sealing material and having moisture resistance.

### Advantageous Effects of Invention

According to the present invention, a dry state of gas in an electrical device housing can be maintained while withstanding an expansion force of the gas in the electrical device housing.

### Brief Description of Drawings

[FIG. 1] FIG. 1 is a sectional view illustrating a structure of a power conversion device according to an embodiment of the present invention.
[FIG. 2] FIG. 2 is a sectional view illustrating a structure of a power conversion device according to a first modification of the present invention.
[FIG. 3] FIG. 3 is a partially enlarged sectional view illustrating a structure of an electrical device housing of a power conversion device according to a second modification of the present invention.
[FIG. 4] FIG. 4 is a partially enlarged sectional view illustrating a structure of an electrical device housing of a power conversion device according to a third modification of the present invention.
[FIG. 5] FIG. 5 is a schematic view illustrating a structure of an aircraft according to a fourth modification of the present invention.
[FIG. 6] FIG. 6 is a schematic view illustrating a structure of an aircraft according to a fifth modification of the present invention.
[FIG. 7] FIG. 7 is a schematic view illustrating a structure of an aircraft according to a sixth modification of the present invention.

### Description of Embodiments

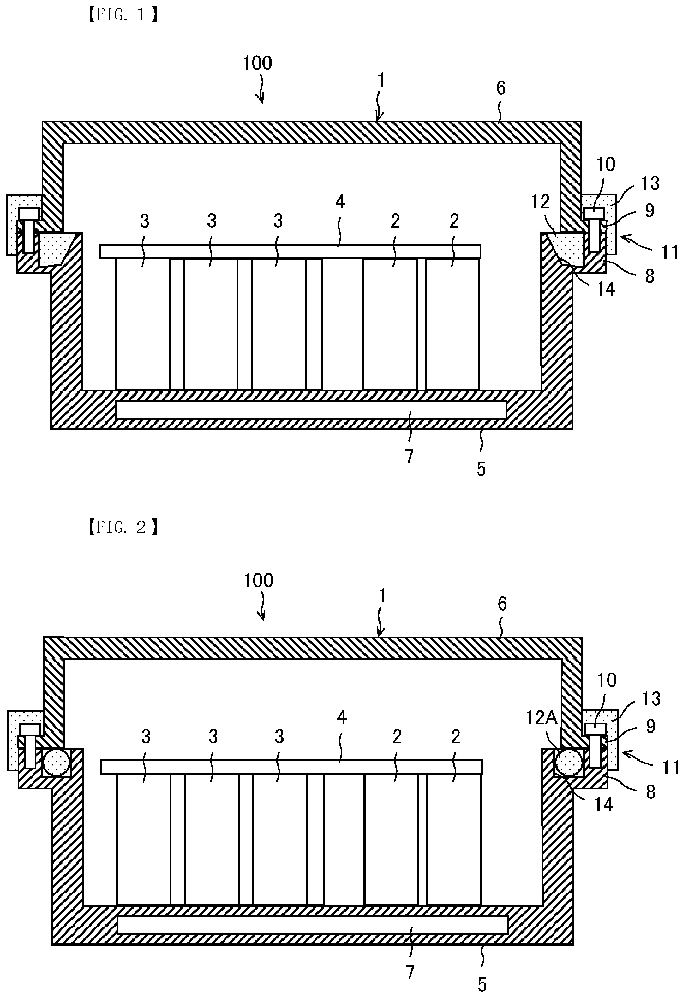

An embodiment of the present invention will be described with reference to FIG. 1. FIG. 1 is a sectional view illustrating a structure of a power conversion device according to the present embodiment.

A power conversion device 100 of the present embodiment is mounted on a moving body (not illustrated) such as an aircraft, transportation equipment, or a construction machine, and includes a plurality of electrical components (in other words, components that function by energization), and an electrical device housing 1 storing the plurality of electrical components.

The plurality of electrical components constitute an electrical circuit and include, for example, a plurality of power conversion elements 2, a plurality of capacitors 3, and a substrate 4. The power conversion element 2 is, for example, an insulated gate bipolar transistor (IGBT). The capacitor 3 is, for example, an electrolytic capacitor, a ceramic capacitor, a film capacitor, or a hybrid capacitor, and is used for smoothing or filtering.

When a pressure valve (not illustrated) for preventing damage to the capacitor 3 is provided, setting pressure inside the electrical device housing 1 during stoppage of operation of the power conversion device 100 to a pressure slightly negative relative to atmospheric pressure is preferable in order to prevent malfunction of the pressure valve.

The electrical device housing 1 includes a housing 5 storing the electrical components described above, and a cover 6 that is connected to the housing 5 and covers an opening of the housing 5. The housing 5 and the cover 6 are, for example, made of metal. Accordingly, even when lightning occurs, a noise current due to the lightning becomes less likely to flow into the electrical components, and malfunction of the electrical components is prevented.

The housing 5 has, as a cooling unit, a cooling passage 7 through which a coolant (specifically, water, mineral oil, Fluorinert, or vegetable oil) flows. The coolant in the cooling passage 7 cools the housing 5 and also cools the electrical components via the housing 5. The cooling unit may use a heat pipe or forced air cooling.

One of a flange portion 8 of the housing 5 and a flange portion 9 of the cover 6 (in the present embodiment, the flange portion 9 of the cover 6) is formed with a plurality of through-holes through which a plurality of bolts 10 respectively pass, and the other (in the present embodiment, the flange portion 8 of the housing 5) is formed with a plurality of threaded holes with which the plurality of bolts 10 are respectively threaded. Then, when the plurality of bolts 10 pass through the through-holes and are threaded into the threaded holes, the flange portion 8 of the housing 5 and the flange portion 9 of the cover 6 are connected. Accordingly, a connection surface (upper surface) of the housing 5 and a connection surface (lower surface) of the cover 6 face each other and are close to each other.

The electrical device housing 1 seals a dry gas therein. The dry gas is, for example, dry air, nitrogen, argon, carbon dioxide, or nitrogen dioxide, and is a gas having a water vapor pressure lower than a saturated water vapor pressure when temperature decreases to a predetermined value (for example, -70°C) due to environmental changes. Accordingly, condensation in the electrical device housing 1 due to environmental changes is prevented, and failure or deterioration of the electrical components is prevented.

The dry gas may include oxygen as a gas having a high electron attachment property, and oxygen concentration may be higher than atmospheric oxygen concentration (21%). Alternatively, the dry gas may include carbon dioxide, sulfur hexafluoride, carbon monoxide, or a halogen-based gas as a gas having a high electron attachment property. Accordingly, discharge of the electrical components may be suppressed, and insulation may be improved.

The electrical device housing 1 includes a sealing part 11 that seals between the connection surface of the housing 5 and the connection surface of the cover 6. The sealing part 11 includes a sealing material 12 (a first sealing material) having elasticity, and a sealing material 13 (a second sealing material) that is disposed outside the sealing material 12 and has moisture resistance. The sealing material 12 having elasticity has waterproofness but does not have moisture resistance, and the sealing material 13 having moisture resistance does not have elasticity.

The sealing material 12 is filled in a groove 14 formed at the connection surface of the housing 5 (in the present embodiment, so as to be located inward of the bolts 10). Considering a case where the connection surface of the cover 6 is rough, the sealing material 12 preferably has a shape or is made of a material that is more easily deformable three-dimensionally than an O-ring. The sealing material 12 is, for example, synthetic rubber, an elastomer, a polymer gel, mortar, or clay. As specific examples of the sealing material 12, from a viewpoint of shortening curing time, a two-liquid curable or ultraviolet curable silicone rubber, or a two-liquid curable or ultraviolet curable urethane, may be used.

The sealing material 13 is attached to outer sides of the housing 5 and the cover 6 so as to extend across a boundary between the connection surface of the housing 5 and the connection surface of the cover 6. The sealing material 13 is, for example, a metal film, and an aluminum vapor-deposited film may be used as a specific example of the metal film. Alternatively, the sealing material 13 is, for example, asphalt roofing. Alternatively, the sealing material 13 is, for example, a resin film, and a film made of polyvinyl, polypropylene, polyethylene, nylon, or polyvinylidene chloride may be used as a specific example of the resin film. Alternatively, the sealing material 13 is, for example, a resin, and a two-liquid curable or ultraviolet curable epoxy resin may be used as a specific example of the resin, or polyvinyl, polypropylene, polyethylene, nylon, or polyvinylidene chloride may be used.

Effects of the sealing part 11 of the electrical device housing 1 of the present embodiment will be described.

For example, when the moving body moves to a high place, pressure outside the electrical device housing 1 of the power conversion device 100 mounted on the moving body decreases. Accordingly, an expansion force of the gas due to a difference between pressure inside the electrical device housing 1 and pressure outside the electrical device housing 1 increases. Of the sealing materials 12 and 13 constituting the sealing part 11, the expansion force of the gas acts on the inner sealing material 12, but does not act on the outer sealing material 13. Because the sealing material 12 has elasticity, the sealing material 12 can withstand the expansion force of the gas. However, the sealing material 12 has waterproofness but does not have moisture resistance. On the other hand, because the sealing material 13 does not have elasticity but has moisture resistance, the sealing material 13 can maintain the dry state of the gas in the electrical device housing 1. Accordingly, according to the sealing part 11 of the electrical device housing 1 of the present embodiment, the dry state of the gas in the electrical device housing 1 can be maintained while withstanding the expansion force of the gas in the electrical device housing 1. As a result, failure or deterioration of the electrical components can be prevented.

In the embodiment described above, the sealing material 12 has been described by taking as an example a case where the sealing material 12 has a shape or material that is more easily deformable three-dimensionally than an O-ring, but the embodiment described above is not limited thereto. Specifically, when the connection surface of the cover 6 is not rough, a sealing material 12A may be an O-ring as in the modification shown in FIG. 2.

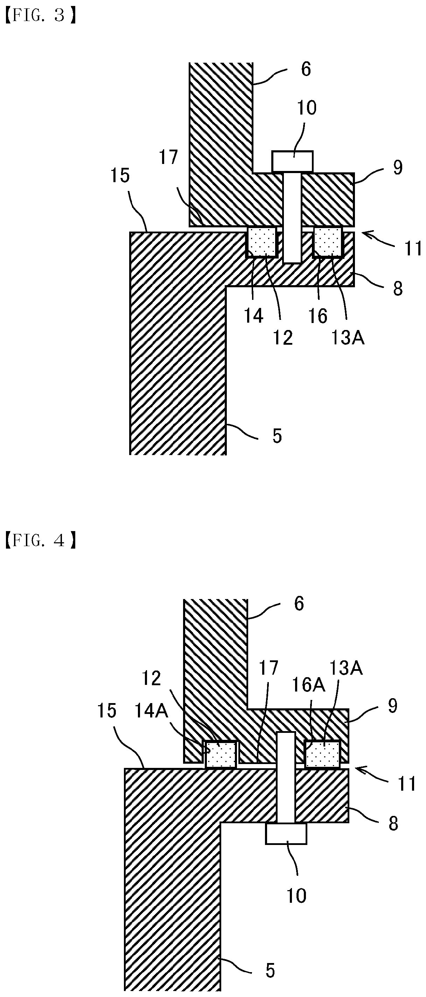

In the embodiment described above, the sealing material 12 has been described by taking as an example a case where the sealing material 12 is disposed in the groove 14 formed at the connection surface of the housing 5 and the sealing material 13 is attached to outer sides of the housing 5 and the cover 6, but the embodiment described above is not limited thereto. For example, as in the modification shown in FIG. 3, a sealing material 13A may be disposed in another groove 16 formed at a connection surface 15 of the housing 5 so as to be located outward of the groove 14 (in the present modification, outward of the bolts 10). In addition, for example, as in the modification shown in FIG. 4, the sealing material 12 may be disposed in a groove 14A formed at a connection surface 17 of the cover 6 (in the present modification, so as to be located inward of the bolts 10). The sealing material 13A may be disposed in another groove 16A formed at the connection surface 17 of the cover 6 so as to be located outward of the groove 14 or 14A (for example, outward of the bolts 10). The sealing material 13A is, for example, a resin, and a two-liquid curable or ultraviolet curable epoxy resin may be used as a specific example of the resin, or polyvinyl, polypropylene, polyethylene, nylon, or polyvinylidene chloride may be used. Also in the modifications described above, effects similar to the effects of the embodiment described above can be obtained.

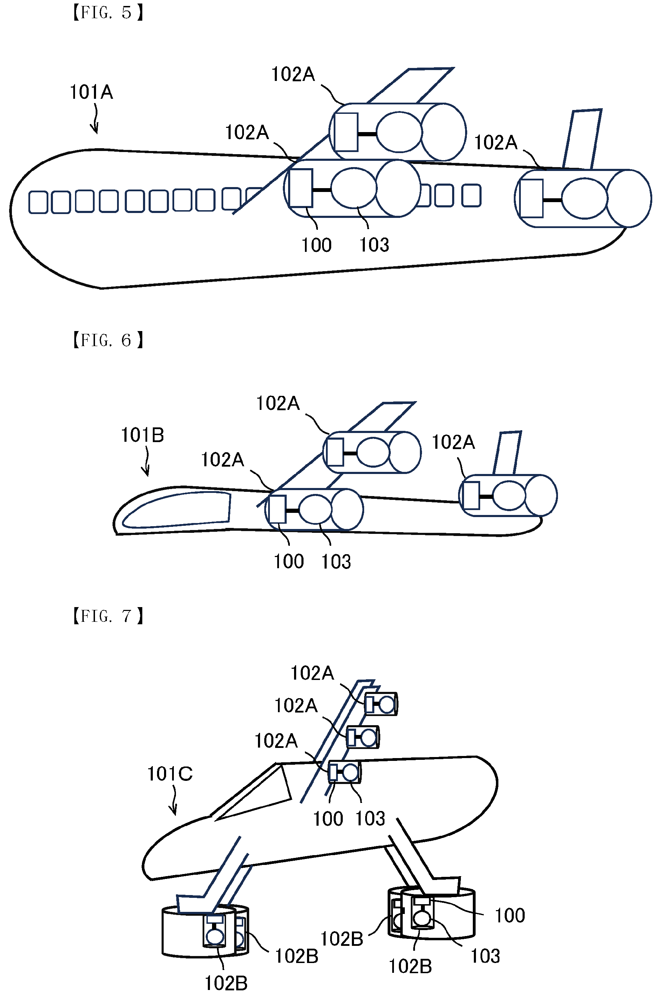

In the embodiment described above, the moving body on which the power conversion device 100 is mounted has been described as an aircraft, transportation equipment, or a construction machine, and specific examples of the moving body will be described with reference to FIGS. 5 to 7. An aircraft 101A for many passengers shown in FIG. 5, or an aircraft 101B for a small number of passengers shown in FIG. 6, includes a plurality of drive devices 102A. An aircraft 101C for a small number of passengers shown in FIG. 7 includes a plurality of drive devices 102A and 102B. The drive device 102A includes the power conversion device 100 that converts power of a secondary battery (not illustrated), an electric motor 103 rotating with power converted by the power conversion device 100, and a propulsion fan (not illustrated) rotated by the electric motor 103 and generating forward thrust. The drive device 102B includes the power conversion device 100 that converts power of a secondary battery (not illustrated), the electric motor 103 rotating with power converted by the power conversion device 100, and a propulsion fan (not illustrated) rotated by the electric motor 103 and generating upward thrust.

Although the case where the present invention is applied to the power conversion device 100, which is one electrical device, has been described above as an example, the present invention is not limited thereto, and the present invention may be applied to another electrical device.

### Reference Signs List

1 electrical device housing
2 power conversion element
3 capacitor
4 substrate
5 housing
6 cover
11 sealing part
12, 12A sealing material (first sealing material)
13, 13A sealing material (second sealing material)
14, 14A groove
15 connection surface
16, 16A another groove
17 connection surface
100 power conversion device (Electrical device)
101A, 101B, 101C aircraft

## Claims

1. An electrical device comprising: an electrical component; a housing that stores the electrical component; a cover that is connected to the housing and covers an opening of the housing; and a sealing part that seals between a connection surface of the housing and a connection surface of the cover facing each other, the electrical device having a dry gas sealed inside the housing and the cover,
wherein the sealing part includes a first sealing material having elasticity, and a second sealing material disposed outside the first sealing material and having moisture resistance.

2. The electrical device according to claim 1, wherein
the first sealing material is disposed in a groove formed at the connection surface of the housing or the connection surface of the cover.

3. The electrical device according to claim 2, wherein
the second sealing material is attached to outer sides of the housing and the cover so as to extend across a boundary between the connection surface of the housing and the connection surface of the cover.

4. The electrical device according to claim 2, wherein
the second sealing material is disposed in another groove formed at the connection surface of the housing or the connection surface of the cover so as to be located outward of the groove.

5. The electrical device according to claim 2, wherein
the first sealing material is synthetic rubber, an elastomer, a polymer gel, mortar, or clay.

6. The electrical device according to claim 3, wherein
the second sealing material is a metal film, a resin film, or asphalt roofing.

7. The electrical device according to claim 3 or 4, wherein
the second sealing material is an epoxy resin, polyvinyl, polypropylene, polyethylene, nylon, or polyvinylidene chloride.

8. An electrical device housing comprising: a housing that stores an electrical component; a cover that is connected to the housing and covers an opening of the housing; and a sealing part that seals between a connection surface of the housing and a connection surface of the cover facing each other, the electrical device housing having a dry gas sealed inside the housing and the cover,
wherein the sealing part includes a first sealing material having elasticity and a second sealing material disposed outside the first sealing material and having moisture resistance.

9. The electrical device housing according to claim 8, wherein
the first sealing material is disposed in a groove formed at the connection surface of the housing or the connection surface of the cover.

10. The electrical device housing according to claim 9, wherein
the second sealing material is attached to outer sides of the housing and the cover so as to extend across between the connection surface of the housing and the connection surface of the cover.

11. The electrical device housing according to claim 9, wherein
the second sealing material is disposed in another groove formed at the connection surface of the housing or the connection surface of the cover so as to be located outward of the groove.

12. The electrical device housing according to claim 9, wherein
the first sealing material is synthetic rubber, an elastomer, a polymer gel, mortar, or clay.

13. The electrical device housing according to claim 10, wherein
the second sealing material is a metal film, a resin film, or asphalt roofing.

14. The electrical device housing according to claim 10 or 11, wherein
the second sealing material is an epoxy resin, polyvinyl, polypropylene, polyethylene, nylon, or polyvinylidene chloride.

15. An aircraft comprising the electrical device according to claim 1.
